# EUROPÄISCHE PATENTSCHRIFT

(11) **EP 1 817 440 B1**
(45) Veröffentlichungstag und Bekanntmachung des Hinweises auf die Patenterteilung: **30.01.2013**
(21) Anmeldenummer: 05815637.3
(22) Anmeldetag: 18.11.2005
(51) Int. Cl.: H01L 21/687, C23C 16/56, C23C 16/458, C30B 25/12, C30B 29/40

(54) **VERFAHREN UND VORRICHTUNG ZUM ABSCHEIDEN VON DICKEN GALLIUM-NITRIT-SCHICHTEN AUF EINEM SAPHIRSUBSTRAT UND ZUGEHÖRIGEM SUBSTRATHALTER**
METHOD AND DEVICE FOR THE DEPOSITION OF GALLIUM NITRITE LAYERS ON A SAPPHIRE SUBSTRATE AND ASSOCIATED SUBSTRATE HOLDER
PROCEDE ET DISPOSITIF POUR DEPOSER DES COUCHES EPAISSES DE NITRITE DE GALLIUM SUR UN SUBSTRAT DE SAPHIR ET PORTE-SUBSTRAT ASSOCIE

(30) Priorität: 04.12.2004 DE 102004058521
(43) Veröffentlichungstag der Anmeldung: 15.08.2007
(73) Patentinhaber: Aixtron SE, 52134 Herzogenrath (DE)
(72) Erfinder: KÄPPELER, Johannes, 52146 Würselen (DE)
(74) Vertreter: Grundmann, Dirk
(86) Internationale Anmeldenummer: PCT/EP2005/056049
(87) Internationale Veröffentlichungsnummer: WO 2006/058847

(56) Entgegenhaltungen:
- WO-A-01/23648
- WO-A-2004/009299
- US-A- 5 169 684
- US-A1- 2001 049 201

## Beschreibung

Die Erfindung betrifft eine Vorrichtung zur Halterung mindestens eines Substrates in einer Prozesskammer eines Reaktorgehäuses mit einer Angriffszone zum Angriff einer Handhabungseinrichtung und mit einer Auflagezone, auf welcher das Substrat zumindest mit seinem Rand aufliegt.

Die Erfindung betrifft darüber hinaus eine Beschichtungsvorrichtung, insbesondere in Form eines MOCVD-Reaktors, vorzugsweise eines HVPE-Reaktors, mit einer Prozesskammer zum Abscheiden von Schichten auf mindestens einem von einem Substrathalter gehaltenen Substrat, welche Prozesskammer von einer Heizung auf Prozesstemperatur gebracht wird.

Ferner betrifft die Erfindung ein Verfahren zum Abscheiden mindestens einer Schicht auf mindestens einem Substrat, wobei das Substrat in einer Prozesskammer eines Reaktorgehäuses auf einem Substrathalter bei einer Prozesstemperatur beschichtet wird und daran anschließend ohne wesentliche Abkühlung oder Erwärmung von unten her lichtbeaufschlagt wird, um die Schicht vom Substrat zumindest anzulösen.

Das US 6,750,121 B1 bzw. WO 2001/023648 A1 beschreibt ein Verfahren zum Abscheiden von Gallium-Nitrit-Schichten auf einem Saphir-Substrat, wobei die thermischen Eigenschaften von Schicht und Substrat derart verschieden sind, dass zufolge unterschiedlicher Wärmeausdehnungskoeffizienten beim Abkühlen des bei einer relativ hohen Prozesstemperatur abgeschiedenen Schichtmaterials Brüche entstehen können.

Zur Vermeidung derartiger Brüche wird von der US 6,750,121 B1 vorgeschlagen, dass das Substrat von unten her bei im Wesentlichen der Prozesstemperatur mit Laserlicht behandelt wird, das durch die Saphirschicht hindurch dringt und die Gallium-Nitrit-Schicht zumindest von der Substratoberfläche anlöst, so dass die ansonsten beim Abkühlen entstehenden Brüche vermieden werden. Die so entstandene Nitrit-Schicht kann später als Substrat für andere Beschichtungsverfahren verwendet werden. Sie wird dann in weiteren Prozessschichten vollständig von dem Saphirsubstrat abgelöst.

Aus der DE 102 32 731, bzw. WO 2004/009299 A2 ist eine Be- und Entladevorrichtung einer Prozesskammer einer Beschichtungseinrichtung bekannt, bei der mittels eines Greifers ein Substrathalter von einem Substrathalterträger abgehoben wird, wobei der Substrathalter eine Ringform besitzt und das Substrat randseitig unterfasst.

Die US 5,169, 684 beschreibt einen ringförmigen Substrathalter, um eine Vielzahl von Substraten parallel zueinander liegend in einer Prozesskammer anzuordnen.

Ausgehend von dem zuvor genannten Stand der Technik liegt der Erfindung die Aufgabe zugrunde, Mittel anzugeben, mit denen in verbesserter Weise Schichten auf Substrate abscheidbar sind, bei denen die Wärmeausdehnungseigenschaften von Schicht und Substrat verschieden sind und insbesondere Gallium-Nitrit-Substrate herstellbar sind. Insbesondere soll das Abscheiden von ein oder mehreren dicken Gallium-Nitrit-Schichten auf einem Saphirsubstrat, welche Schichten später wieder von den Substraten abgelöst werden können, verbessert werden.

Gelöst wird die Aufgabe zunächst und im Wesentlichen durch die in den nebengeordneten Ansprüchen 1, 6 und 11 angegebene Erfindung. Die Unteransprüche stellen vorteilhafte Weiterbildungen der Erfindung dar.

Der Substrathalter wird erfindungsgemäß dadurch weitergebildet, dass die Auflagezone für die Wellenlänge des optischen Substratbehandlungsprozesses transparent ist. Zufolge dieser Ausgestaltung kann die der Beschichtung nachfolgende optische Behandlung auf ein und demselben Substrathalter durchgeführt werden. Dieser kann mit einer Handhabungseinrichtung, wie sie von der DE 10 232 731 beschrieben ist, von der Prozesskammer in eine Behandlungskammer transferiert werden, wobei die Behandlungskammer vorzugsweise unmittelbar neben der Prozesskammer angeordnet ist und auf im Wesentlichen derselben Temperatur wie die Prozesskammer gehalten ist. Es ist auch möglich, dass die Prozesskammer und die Behandlungskammer lediglich durch eine Trennwand voneinander getrennt werden. Beide Kammern können auch Abschnitte ein und desselben Raumes sein. In einer bevorzugten Ausgestaltung besitzt der Substrathalter eine Ringform. Hierzu kann der Substrathalter einen kreisringförmigen Grundkörper besitzen. Der zentrale Freiraum dieses Grundkörpers besitzt einen Grundriss, der etwas größer ist als die Fläche des Substrates. Zufolge dieser Ausgestaltung kann die gesamte Substratoberfläche von unten her mit einem Laserstrahl behandelt werden, welcher durch den zentralen Freiraum des Grundkörpers hindurch die Unterseite des Substrates beaufschlagt. Die Auflagezone wird vorzugsweise von einem auf dem Grundkörper aufliegenden Stützelement ausgebildet. Das Stützelement kann aber auch anderweitig mit dem Grundkörper verbunden sein. Wesentlich ist, dass das Stützelement transparent ist für die Wellenlänge des optischen Substratbehandlungsprozesses. Dabei kann das Stützelement einteilig oder mehrteilig ausgebildet sein. Es sollte aber Abschnitte aufweisen, die in den zentralen Freiraum ragen, um damit das Substrat zu tragen. Das Stützelement besteht vorzugsweise aus demselben Material wie das Substrat, also vorzugsweise aus Saphir (Al₂O₃). Es ist auch möglich, dass mehrere Substrate auf einem Substrathalter aufliegen. Hierzu kann der Substrathalter gitterartig eine Vielzahl von Öffnungen aufweisen, auf deren Rand der Rand des Substrates aufliegt. Da das Stützelement vorzugsweise transparent für die zur Behandlung erforderliche Wellenlänge ist, ist es auch möglich, dass das Substrat vollflächig auf einem derartigen Stützelement aufliegt. Vorzugsweise besitzt das Stützelement jedoch eine Kreisscheibenform und liegt auf einer Stufe des Grundkörpers auf. Der CVD-Reaktor, der die Prozesskammer bildet, besitzt neben geeigneten Gaseinlasseinrichtungen auch zumindest eine Gasauslasseinrichtung und eine Heizung zum Aufheizen des Substrates bzw. des Substrathalters oder eines den Substrathalter tragenden Substrathalterträger. Diese Heizung kann eine Widerstandsheizung sein. Sie kann eine Infrarotheizung oder eine RF-Heizung sein. In der Prozesskammer befindet sich bevorzugt eine Substathalterträger, auf den mittels einer Handhabungseinrichtung der Substrathalter aufgesetzt werden kann. Der Substrathalterträger besitzt vorzugsweise einen Sockel, über den der ringförmige Substrathalter derart gestülpt werden kann, dass das Stützelement auf dem Sockel aufliegt. Der Substrathalterträger kann in einer Öffnung des Bodens der Prozesskammer einliegen. Der Boden dieser Öffnung besitzt Austrittsdüsen für Gase, die ein Gaspolster ausbilden, auf welchem der Substrathalterträger schwebend drehangetrieben wird. Der Substrathalterträger wird vorzugsweise auch mit dem aus dem Boden der Öffnung austretenden Gas drehangetrieben. Der Prozesskammer ist eine Behandlungskammer angegliedert. In dieser findet die optische Nachbehandlung bei im Wesentlichen derselben Prozesstemperatur statt. Hierzu wird der Substrathalter mit darauf aufliegendem Substrat nach dort mittels Handhabungseinrichtung verbracht. Auch hier kann die Beheizung in der oben beschriebenen Weise von unten erfolgen. Die Lichtbeaufschlagung des Substrates von unten erfolgt mittels eines Laserstrahls bei einer Wellenlänge von z. B. 355 nm. Es kann sich daher um einen Laserarray handeln, das in einer Vertiefung des Bodens der Behandlungskammer einliegt. Es ist aber auch möglich, einen richtungsbeeinflussbaren einzelnen Laser zu verwenden, der zeilenweise oder spiralförmig die komplette Fläche des Substrates abtastet. Der Prozess findet bei den gängigen Prozessdrucken statt, also in einem Bereich zwischen 10 und 1000 hPa. Auch die optische Behandlung kann bei diesen Totaldrucken stattfinden. Die Prozesskammer und die Behandlungskammer werden in geeigneter Weise durch Inertgase wie Edelgase oder Stickstoff oder Wasserstoff gespült. Darüber hinaus können oberflächenstabilisierende Gase wie Ammoniak eingesetzt werden.

Ausführungsbeispiele der Erfindung werden nachfolgend anhand beigefügter Zeichnungen erläutert. Es zeigen:
- Fig. 1: in einem Halbschnitt in perspektivischer Darstellung einen Substrathalter eines ersten Ausführungsbeispiels mit aufliegendem Substrat,

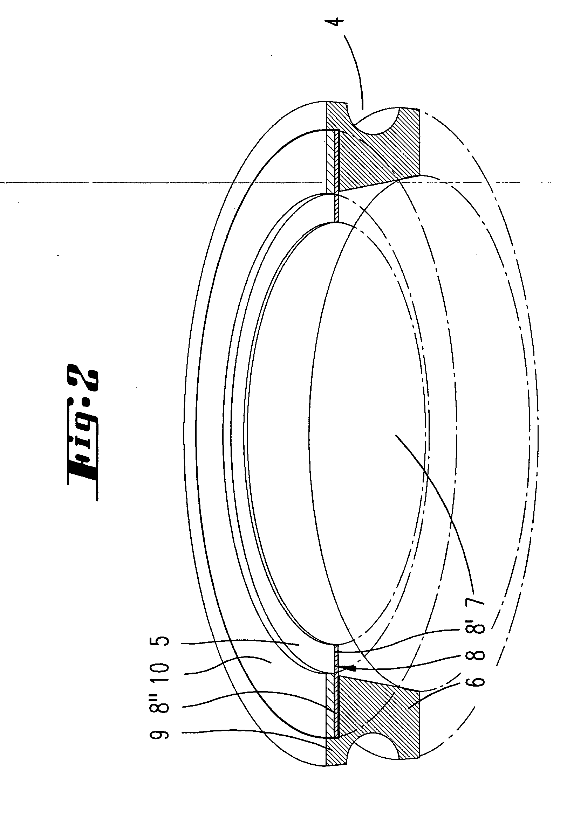

- Fig. 2: eine perspektivische Darstellung des Substrathalters des ersten Ausführungsbeispiels (Fig. 1) ohne darauf aufliegendem Substrat,
- Fig. 3: in schematischer Darstellung im Schnitt ein Reaktorgehäuse mit Prozesskammer und daran angegliederter Behandlungskammer, Fig. 4 eine zweites Ausführungsbeispiel eines Substrathalters in einer Darstellung gemäß Fig. 1,
- Fig. 5: die Draufsicht auf ein weiteres Ausführungsbeispiel, bei dem drei unterschiedlich ausgestaltete Substrathalter auf einem Substrathalterträger aufliegen,
- Fig. 6: ein weiteres Ausführungsbeispiel der Erfindung in einer Darstellung gemäß Fig. 3,
- Fig. 7: ein weiteres Ausführungsbeispiel in einer Behandlungskammer in einer Darstellung gemäß Fig. 3,
- Fig. 8a: eine mögliche Abtastkurve eines steuerbaren Lasers,
- Fig. 8b: eine zweite mögliche Abtastkurve eines steuerbaren Lasers,
- Fig. 9: ein weiteres Ausführungsbeispiel eines Grundkörpers im Schnitt und
- Fig. 10: ein weiteres Ausführungsbeispiel eines Grundkörpers mit Draufsicht in einer Darstellung gemäß Fig. 1.

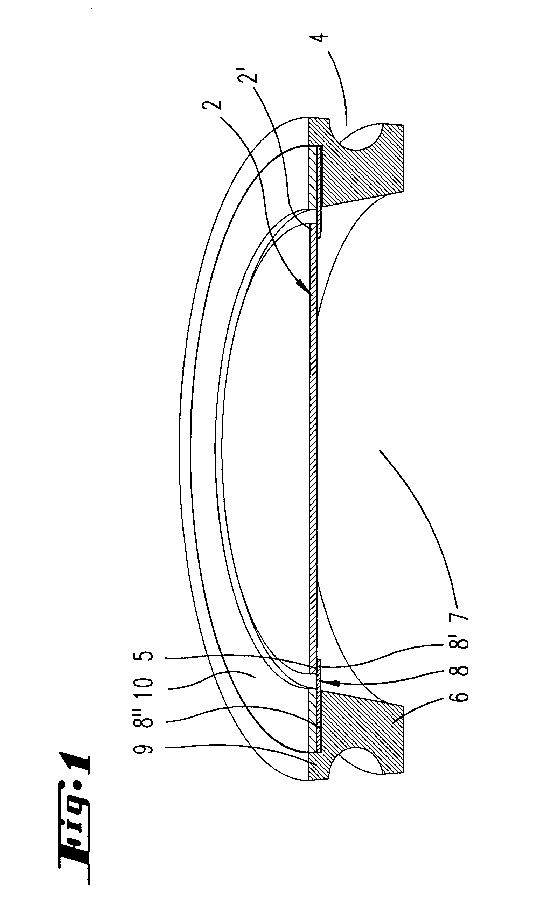

Das in Fig. 1 dargestellte Ausführungsbeispiel ist ein Substrathalter 1, der einen ringförmigen, aus SIC, TaC oder pyrolitischen BN beschichteten Graphit oder aus Quarzglas bestehenden Grundkörper 6 besitzt. Dieser Grundkörper besitzt eine außenwandseitige, umlaufende Nut, die eine Angriffszone ausbildet für eine gabelförmige Handhabungseinrichtung, wie sie beispielsweise von der DE 10 232 731 beschrieben wird. Der Innenraum 7 des rotationssymmetrischen, ringförmigen Grundkörpers 6 besitzt einen Durchmesser, der größer ist, als der Durchmesser des Substrates 2.

Unter Ausbildung einer Randrippe 9 bildet die Oberseite des Grundkörpers 6 eine Stufe aus. Auf dieser Stufe liegt ein kreisringscheibenförmiger Saphirkörper 8, der ein Stützelement ausbildet. Mit seinem Außenrand 8" liegt das Stützelement 8 auf der Stufe auf. Der innere Randabschnitt 8' des Stützelementes 8 ragt in den zentralen Freiraum 7 des Grundkörpers 6.

Dieser, in den Freiraum 7 hinein ragende Rand 8' bildet eine Auflagezone 5 für den Rand 2' des Substrates 2 aus. Die Randrippe 9 dient der Zentrierung des Stützelementes 8. Die Randrippe 9 ist etwas höher als die Materialstärke des aus Saphir bestehenden Stützelementes 8, so dass auch ein auf dem Rand 8" des Stützelementes 8 aufliegender ringscheibenförmiger Graphit- oder Quarzkörper 10, der eine Kompensationsplatte bildet, zentriert werden kann. Die Dicke dieser Kompensationsplatte 10 entspricht im Wesentlichen der Dicke des Substrates 2. Die Kompensationsplatte 10 dient der Zentrierung des Substrates. Die innere Kante der ringförmigen Kompensationsplatte 10 fluchtet in etwa mit der inneren Wandung des Grundkörpers 6.

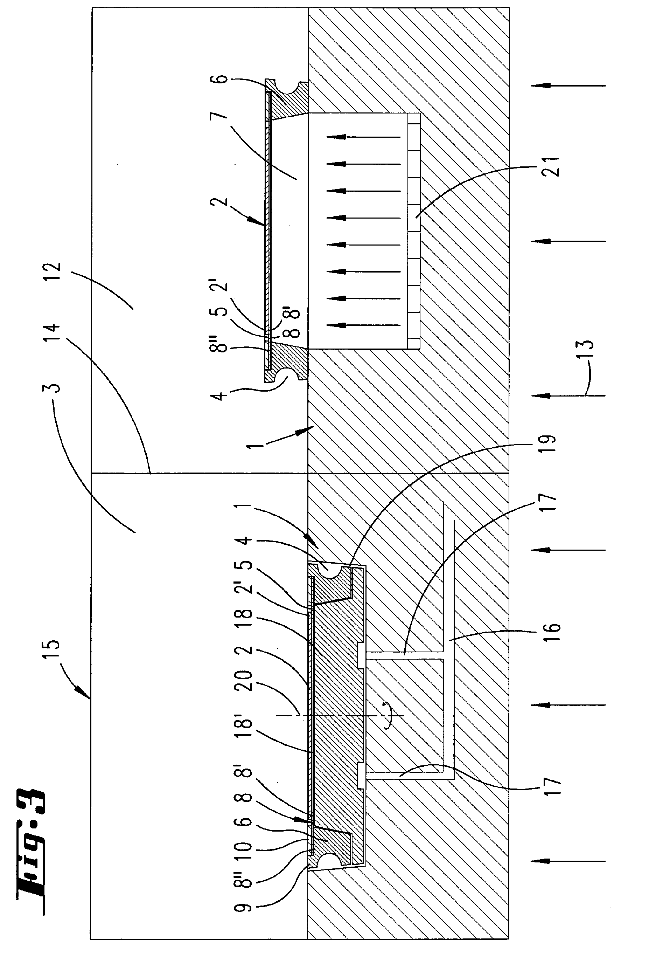

Die Fig. 3 zeigt grob schematisch ein Reaktorgehäuse 15, welches eine Prozesskammer 3 und daran angegliedert eine Behandlungskammer 12 besitzt. Die Prozesskammer 3 ist von einer Trennwand 14 von der Behandlungskammer 12 getrennt.

In die Prozesskammer 3 münden nicht dargestellte Gaseinlässe, um beispielsweise die zur Schichtabscheidung dienenden reaktiven Gase in die Prozesskammer 3 einzuleiten. Bei diesen Gasen handelt es sich um Hydride und Chloride, vorzugsweise um Gallium-Chlorid und um Ammoniak. Durch Reaktionen in der Gasphase, die auch plasmaunterstützt sein können, zerfallen die reaktiven Gase miteinander oder werden zumindest derart thermisch angeregt, dass auf der Oberfläche des Substrates eine Gallium-Nitrit-Schicht abgeschieden wird. Das Substrat 2 besteht aus einem Saphir. Darüber hinaus besitzt die Prozesskammer 3 nicht dargestellte Mittel, um das Prozessgas bzw. die Reaktionsprodukte aus der Prozesskammer abzuleiten. Diese Mittel können eine Vakuumpumpe mit umfassen.

Der Boden der Prozesskammer 3 bildet eine Vertiefung 19 aus. Im Boden der Vertiefung 19 sind Düsen 17 angeordnet, die mit einer Gaszuleitung 16 verbunden sind. Aus den Düsen 17 treten Gasströme aus, die einen in der Vertiefung 19 einliegenden Substrathalterträger 18 anheben und in Drehung versetzen. Der Substrathalterträger 18 ist vorzugsweise aus beschichtetem Graphit gefertigt und bildet einen Sockel aus, auf den der Substrathalter 1 mittels einer nicht dargestellten Handhabungseinrichtung aufsetzbar ist. Dabei ragt der Sockel des Substrathalterträgers 18 in den zentralen Freiraum 7 des Grundkörpers 6 hinein. Der Substrathalter 1 und der Substrathalterträger 18 sowie alle anderen Elemente der Prozesskammer 3 können aus jedem geeigneten, hochtemperaturfesten Material gefertigt sein. Im Ausführungsbeispiel stützt sich der nach innen ragende Rand 8' des Stützelementes 8 auf der Oberseite des Sockels ab. Der Grundkörper 6 liegt in einer kreisringförmigen Aussparung, die die Wandung der Vertiefung 19 einerseits und die Außenwandung des Sockels andererseits bildet.

Durch Einleiten der vorerwähnten Gase und zusätzlicher Trägergase wie Wasserstoff oder Stickstoff und Beheizen der Prozesskammer 3 wird die chemische Reaktion in Gang gesetzt.

Die Beheizung der Prozesskammer 13 kann von allen Seiten erfolgen. In der Fig. 3 ist die Beheizung durch die Pfeile lediglich angedeutet.

In unmittelbarer Nachbarschaft, insbesondere im selben Reaktorgehäuse 15 ist die Behandlungskammer 12 vorgesehen. In dieser herrscht im Wesentlichen dieselbe Temperatur, die auch in der Prozesskammer 3 herrscht. Die Temperatur innerhalb der Behandlungskammer kann aber auch geringer sein, als die Temperatur innerhalb der Prozesskammer 3. Wesentlich ist, dass der Temperaturunterschied gering genug ist, um die oben genannten Schädigungen zu vermeiden. Dorthin treten jedoch keine reaktiven Gase ein. Zur Abschottung dient eine Trennwand 14. Es ist aber auch möglich, die Trennwand 14 wegzulassen.

Der Boden der Behandlungskammer 12 bildet im Ausführungsbeispiel eine Vertiefung aus. Auf dem Boden der Vertiefung ist eine Laseranordnung 21 angeordnet, die Licht einer Wellenlänge 355 nm absendet. Für andere Prozesse können aber auch andere Wellenlängen emittiert werden.

Das von der Laseranordnung 21 emittierte Licht durchdringt den Rand 8' der aus Saphir bestehenden Kreisringscheibe 8 und das gesamte Substrat 2, also auch den Randabschnitt 2' des Substrates 2, der auf der Kreisringscheibe aufliegt. Zufolge der eingebrachten Lichtenergie verändert sich das Interface zwischen Substrat und darauf aufgebrachter Gallium-Nitrit-Schicht derartig, dass es aufweicht. Die Gallium-Nitrit-Schicht wird dadurch von der Substratoberfläche angelöst. Eine eventuell vorhandene kristalline Anbindung zwischen Schicht und Substrat wird zerstört. Im Bereich des Interfaces kann amorphes Material entstehen.

Es ist auch vorgesehen, dass während der optischen Behandlung die Prozesstemperatur innerhalb der Behandlungskammer 12 von einer Temperatur, die unterhalb der Prozesstemperatur liegt, weiter abgesenkt wird.

Zur Durchführung des Verfahrens wird zunächst der Substrathalter mit darauf aufliegendem Substrat in die Prozesskammer 3 eingebracht. Dort wird in der an sich bekannten Weise eine Gallium-Nitrit-Schicht von mehreren Mikrometern Dicke auf das aus -Saphir bestehende Substrat 2 aufgebracht. Sodann wird der Substrathalter mit darauf aufliegendem Substrat 2 mit einer Handhabungseinrichtung in die Behandlungskammer 12 verbracht, wo das Substrat 2 von unten mit Laserlicht beaufschlagt wird, damit sich die Gallium-Nitrit-Schicht von dem Saphirsubstrat löst. Beide Prozesse können im Wesentlichen bei derselben Prozesstemperatur von etwa 1000 oder 1100° C durchgeführt werden.

Sodann wird der Substrathalter 1 mit darauf aufliegendem Substrat 2 aus der Behandlungskammer 12 mittels einer Handhabungseinrichtung verbracht und abgekühlt. Beim Abkühlen kann sich die Schicht gegenüber dem Substrat in lateraler Richtung verschieben, so dass es nicht zu Brüchen kommt.

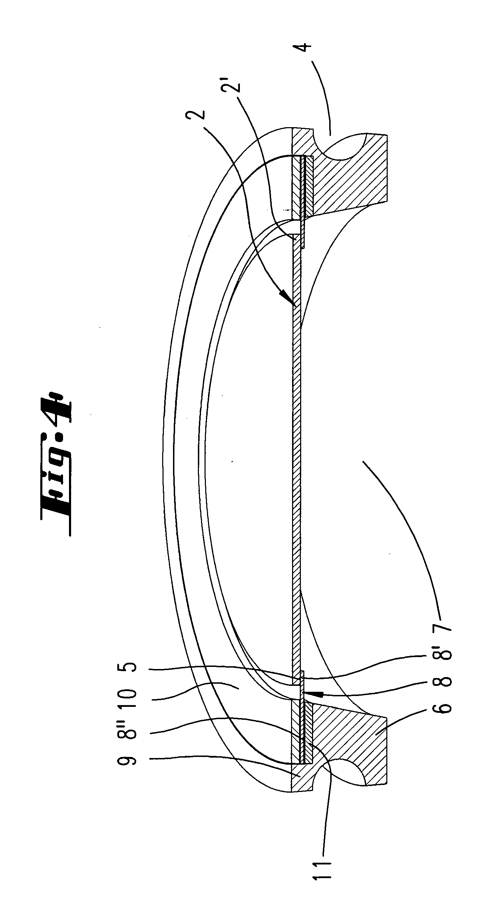

Bei dem in der Fig. 4 dargestellten weiteren Ausführungsbeispiel liegt unterhalb der Kreisringscheibe 8 noch eine kreisringscheibenförmige Unterlegplatte, die auf der vom Grundkörper ausgebildeten Stufe liegt.

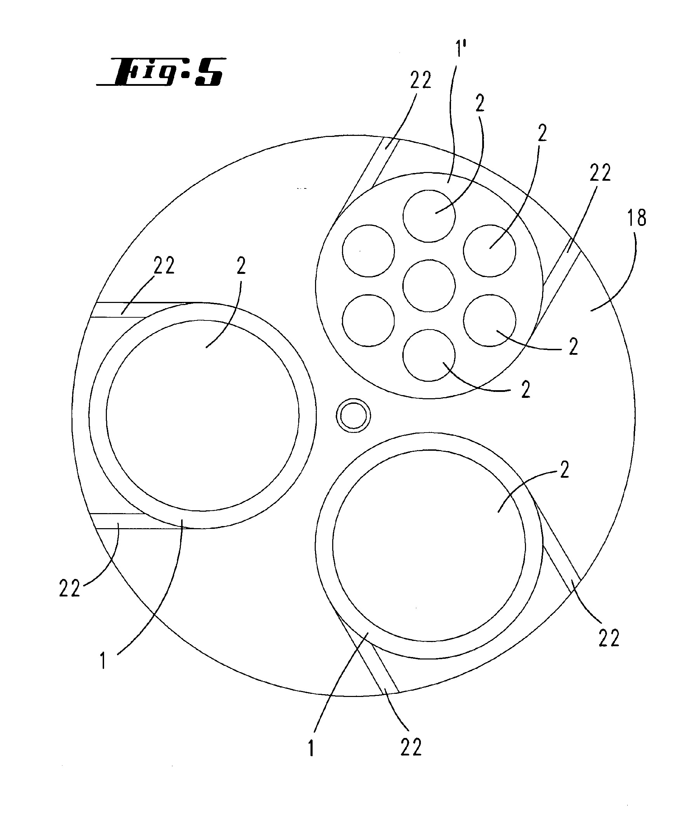

Bei dem in Fig. 5 dargestellten Ausführungsbeispiel trägt der Substrathalter 18 insgesamt drei Substrathalter 1,1'. Die Substrathalter 1 haben die Gestalt, wie sie zuvor beschrieben wurde. Der Substrathalter 1' ist andersartig gestaltet. Er ist in der Lage, eine Vielzahl von Substraten 2 zu tragen.

Der Zugriff der gabelförmigen Handhabungseinrichtung erfolgt über Kanäle 22, wie dies in der DE 10 232 731 beschrieben wird.

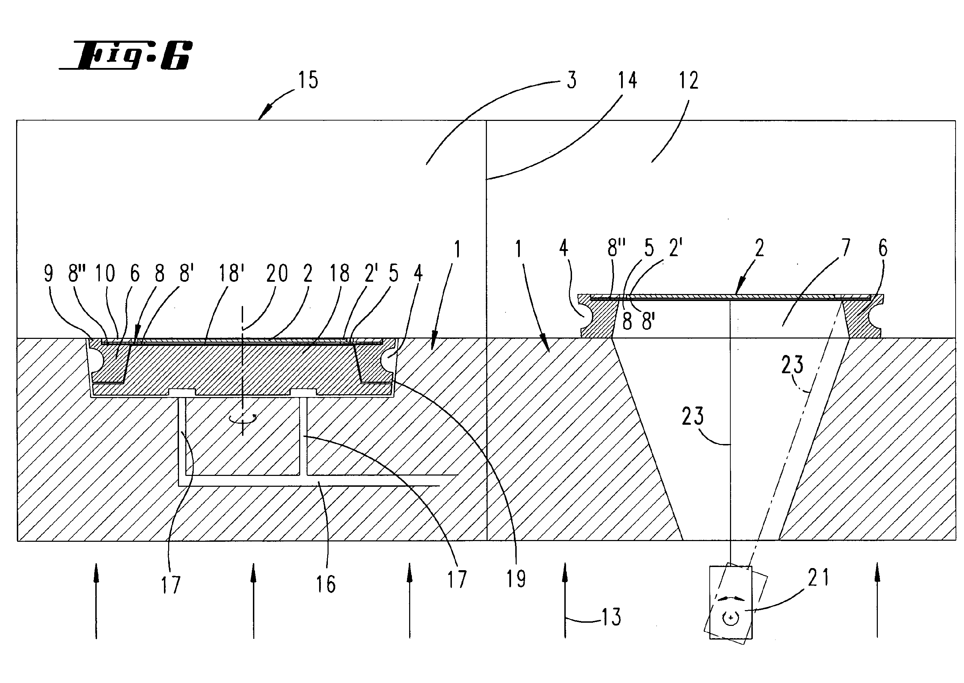

Bei dem in der Fig. 6 dargestellten Ausführungsbeispiel besitzt die Behandlungskammer 2 einen Boden mit einer trichterförmigen Öffnung. Im Eingangsbereich der trichterförmigen Öffnung befindet sich ein positionierbarer Laser 21. Dieser kann um verschiedene Schwenkachsen geschwenkt werden, um mit seinem Laserstrahl 23 die Unterfläche des Substrates abzutasten.

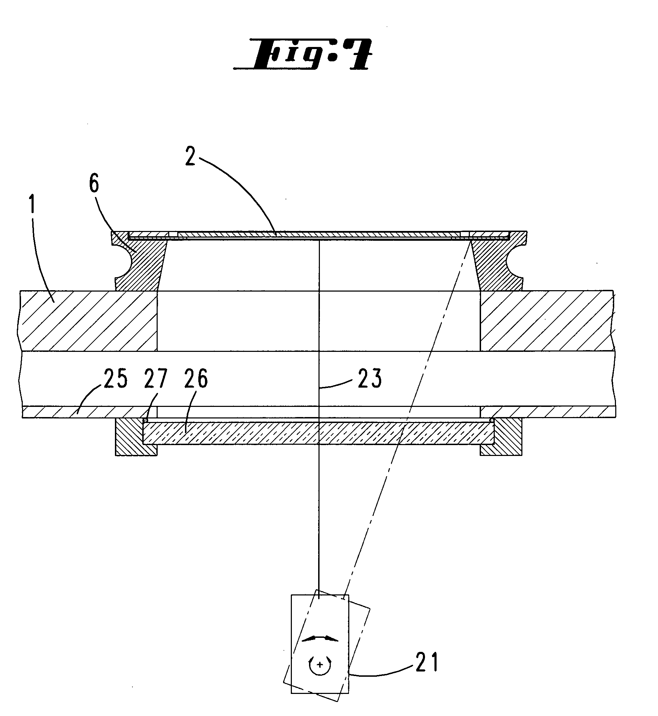

Bei dem in Fig. 7 dargestellten Ausführungsbeispiel besitzt die unterhalb des Substrathalters 1 angeordnete Reaktorwandung 25 eine Öffnung, die mit der Zwischenlage einer Dichtung 27 von einem Fenster 26 verschlossen ist, das sich auf einem Rahmen 28 abstützt. Unterhalb des Fensters 26, also außerhalb der eigentlichen Prozesskammer bzw. Reaktorkammer, in welcher sich ein Vakuum befinden kann, befindet sich die Laseranordnung 21. Auch hier handelt es sich um einen schwenkbaren Laser, dessen Laserstrahl 23 die Unterfläche des Substrates abtasten kann, um so die dicke Gallium-Nitrit-Schicht von dem transparenten Substrat abzulösen.

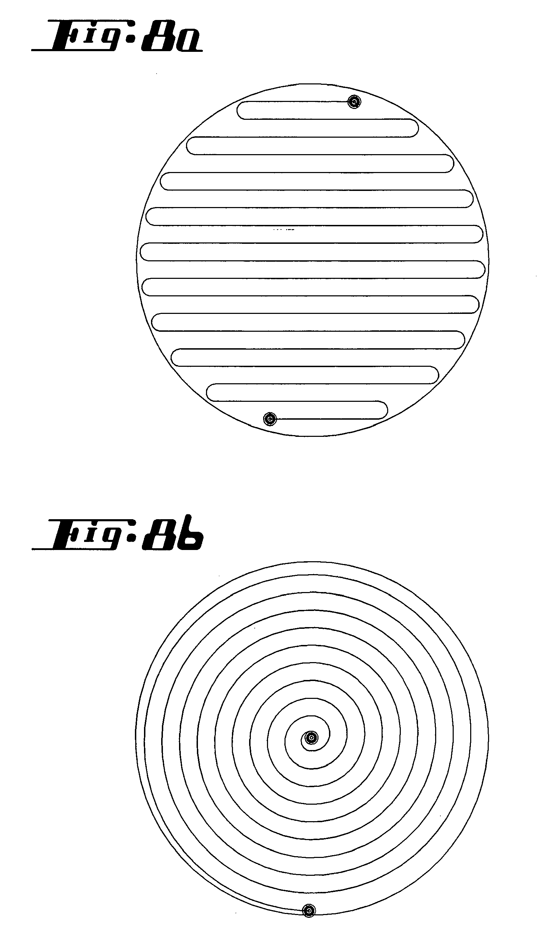

Der Laser kann dabei die Substratunterseite wie in der Fig. 8a dargestellt, zeilenweise abtasten. Es ist aber auch möglich, wie in der Fig. 8b dargestellt, die Unterseite des Substrates spiralförmig abzutasten. Dies kann von innen nach außen oder von außen nach innen erfolgen. Vorzugsweise erfolgt das Abtasten von außen nach innen. Und dabei kann sogar gleichzeitig die Temperatur abgesenkt werden.

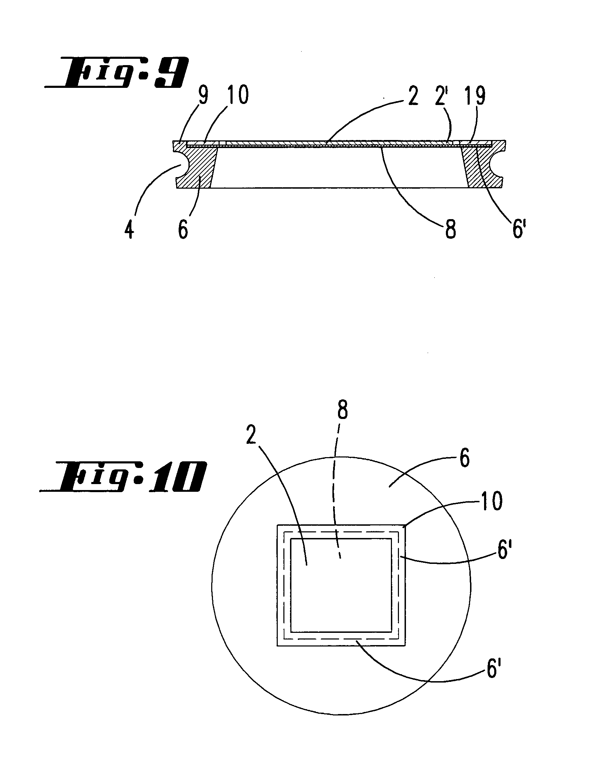

Bei dem in der Fig. 9 dargestellten Ausführungsbeispiel ist das Stützelement 8 kreisscheibenförmig ausgebildet. Es ist transparent für den verwendeten Laserstrahl, dessen Wellenlänge beispielsweise 355 nm beträgt. Es stützt das Substrat 2 vollständig ab, da es die Form einer Kreisscheibe besitzt.

Das in Fig. 10 dargestellte Ausführungsbeispiel eines Grundkörpers 6 zeigt eine quadratische Öffnung mit einer Stufe 6', auf welche ein entsprechend geformtes Stützelement 8 aufgelegt werden kann, so dass mit dieser Vorrichtung sowohl runde als auch eckige Substrate behandelt werden können. Auch hier kann wie bei dem in der Fig. 9 dargestellten Ausführungsbeispiel eine Kompensationsplatte 10 vorgesehen sein, die das Substrat in seiner Lage auf dem Stützelement 8 zentriert.

## Patentansprüche

1. Vorrichtung zur Halterung mindestens eines Substrates (2) in einer Prozesskammer (3) eines Reaktorgehäuses (15) mit einer Angriffszone (4) zum Angriff einer Handhabungseinrichtung und mit einer Auflagezone (5), auf welcher das Substrat (2) zumindest mit seinem Rand (2') aufliegt, **dadurch gekennzeichnet, dass** die Auflagezone (5) von einem für die Wellenlänge eines optischen Substratbehandlungsprozesses transparenten Stützelement (8) ausgebildet ist, das auf einem ringförmigen Grundkörper (6) derart aufliegt, dass sich ein oder mehrere Abschnitte (8') des Stützelementes (8) in oder über den zentralen Freiraum des Grundkörpers (6) erstrecken.

2. Vorrichtung nach Anspruch 1, **dadurch gekennzeichnet, dass** das Stützelement (8) aus demselben Material wie das Substrat (2) besteht.

3. Vorrichtung nach einem der vorhergehenden Ansprüche, **dadurch gekennzeichnet, dass** mehrere Substrate (2) auf einem Substrathalter (1) aufliegen.

4. Vorrichtung nach einem der vorhergehenden Ansprüche, **dadurch gekennzeichnet, dass** das Stützelement (8) eine Kreisringscheibenform aufweist und auf einer Stufe des Grundkörpers (6) aufliegt.

5. Vorrichtung nach einem der vorhergehenden Ansprüche, **dadurch gekennzeichnet, dass** das Stützelement (8) aus Saphir (AL₂O₃) besteht.

6. Vorrichtung zum Beschichten eines Substrates, insbesondere CVD-Reaktor mit einer Prozesskammer (3) zum Abscheiden von Schichten auf mindestens einem von einem Substrathalter (1) gemäß einem der Ansprüche 1 bis 5 gehaltenen Substrat (2), welche Prozesskammer (3) on einer Heizung (13) auf Prozesstemperatur gebracht wird, **gekennzeichnet durch** eine der Prozesskammer (3) angegliederte Behandlungskammer (12) zur optischen Nachbehandlung bei im Wesentlichen derselben oder einer etwas geringeren Prozesstemperatur des dorthin auf dem Substrathalter (1) gebrachten mindestens eines Substrates (2).

7. Vorrichtung nach Anspruch 6, **dadurch gekennzeichnet, dass** der Substrathalter (1) in der Prozesskammer (3) auf einem Substrathalterträger (18) aufliegt, der von unten beheizbar ist.

8. Vorrichtung nach Anspruch 6, **dadurch gekennzeichnet, dass** der Substrathalterträger (18) insbesondere auf einem Gaspolster drehangetrieben gelagert ist.

9. Vorrichtung nach einem der Ansprüche 6 bis 8, **dadurch gekennzeichnet, dass** das Stützelement (8) auf dem Substrathalterträger (18) aufliegt.

10. Vorrichtung nach einem der Ansprüche 6 bis 9, **dadurch gekennzeichnet, dass** die Behandlungskammer (12) eine Laseranordnung (21) als Lichtquelle aufweist, die insbesondere ein Licht der Wellenlänge 355 nm emittiert.

11. Verfahren zum Abscheiden mindestens einer Schicht auf mindestens einem Substrat (2), wobei das Substrat (2) in einer Prozesskammer (3) eines Reaktorgehäuses (15) auf einem Substrathalter (1) gemäß einem der vorhergehenden Ansprüche aufliegend bei einer Prozesstemperatur beschichtet wird und daran anschließend ohne wesentliche Abkühlung oder geringe Abkühlung in einer Behandlungskammer (12) auf demselben Substrathalter (1) aufliegend von unten her lichtbeaufschlagt wird, um das Interface zwischen Schicht und Substrat (2) zu beeinflussen und ggf. anzulösen.

12. Verfahren nach Anspruch 11, **dadurch gekennzeichnet, dass** die Prozesstemperatur >900°C, >1000°C oder >1100°C ist.

13. Verfahren nach Anspruch 11 oder 12, **dadurch gekennzeichnet, dass** eine mehrere Mikrometer dicke, insbesondere als Pseudosubstrat dienende Gallium-Nitrit-Schicht auf einem Saphir Substrat abgeschieden wird.

14. Verfahren nach einem der Ansprüche 11 bis 13, **dadurch gekennzeichnet, dass** die Abscheidung durch in die Prozesskammer (3) eingebrachte reaktive Gase erfolgt.

15. Verfahren nach Anspruch 14, **dadurch gekennzeichnet, dass** die in die Prozesskammer eingebrachten Gase Elemente der dritten und fünften bzw. zweiten und sechsten Hauptgruppe beinhalten und insbesondere Chloride und Hydride, bspw. Gallium-Chlorid und NH₃ sind.

## Claims

1. A device for holding at least one substrate (2) in a process chamber (3) of a reactor housing (15) comprising an engagement zone (4) for the engagement of a handling device and comprising a support zone (5), on which the substrate (2) rests at least with its periphery (2'), **characterized in that** the support zone (5) is built by a support element (8) which is transparent to the wavelength of an optical substrate treatment process which rests on an annular basic body (6) in such a manner that one or more portions (8') of the supporting elements (8) extend into or over the central free space of the basic body (6).

2. The device as claimed in claim 1, **characterized in that** the supporting element (8) consists of the same material as the substrate (2).

3. The device as claimed in one of the preceding claims, **characterized in that** a number of substrates (2) rest on a substrate holder (1).

4. The device as claimed in one of the preceding claims, **characterized in that** the supporting element (8) takes the form of an annular disk and rests on a step of the basic body (6).

5. The device as claimed in one of the preceding claims, **characterized in that** the supporting element (8) consists of sapphire (Al₂O₃).

6. A device for coating a substrate, in particular a CVD reactor comprising a process chamber (3) for depositing layers on at least one substrate (2) held by a substrate holder (1), according to one of the preceding claims 1 to 5, which process chamber (3) is brought to process temperature by a heater (13), **characterized by** a treatment chamber (12) attached to the process chamber (3) for the optical aftertreatment at substantially the same or a somewhat lower process temperature of the at least one substrate (2) brought there on the substrate holder (1).

7. The device as claimed in claim 6, **characterized in that**, in the process chamber (3), the substrate holder (1) rests on a substrate holder carrier (18), which can be heated from below.

8. The device as claimed in claim 6, **characterized in that** the substrate holder carrier (18) is mounted in a rotationally driven manner, in particular on a gas cushion.

9. The device as claimed in one of the claims 6 to 8, **characterized in that** the supporting element (8) rests on the substrate holder carrier (18).

10. The device as claimed in one of the claims 6 to 9, **characterized in that** the treatment chamber (12) has a laser arrangement (21) as a light source, which particularly emits a light at a wavelength of 355 nm.

11. A method for depositing at least one layer on at least one substrate (2), the substrate (2) being coated at a process temperature in a process chamber (3) of a reactor housing (15) while resting on a substrate holder (1), in particular as claimed in one of the preceding claims, and then being impinged upon with light from below without significant cooling, or with slight cooling, in a treatment chamber (12) while resting on the same substrate holder (1), in order to influence the interface between the layer and the substrate (2) and possibly partially detach said layer.

12. The method as claimed in claim 11, **characterized in that** the process temperature is > 900°C, > 1000°C or > 1100°C.

13. The method as claimed in claim 11 or 12, **characterized in that** a gallium-nitrite layer several micrometers thick, serving in particular as a pseudo-substrate, is deposited on a sapphire substrate.

14. The device as claimed in claim 11 to 13, **characterized in that** the deposition takes place by reactive gases introduced into the process chamber (3).

15. The device as claimed in claim 14, **characterized in that** the gases introduced into the process chamber comprise elements of the third and fifth or second and sixth main groups and particularly are chlorides and hydrides, for example gallium chloride and NH₃.

## Revendications

1. Dispositif pour maintenir au moins un substrat (2) dans une chambre de réaction (3) d'un boîtier de réacteur (15), ledit dispositif comportant une zone de préhension (4) destinée à saisir un mécanisme de manipulation et une zone d'appui (5) sur laquelle le substrat (2) repose au moins au niveau de son bord (2'), **caractérisé en ce que** la zone d'appui (5) est formée par un élément de soutien (8) qui est transparent à la longueur d'onde d'un processus de traitement optique de substrat et qui repose sur un corps de base annulaire (6) de telle sorte qu'une ou plusieurs portions (8') de l'élément de soutien (8) s'étendent dans ou au-dessus de l'espace libre central du corps de base (6).

2. Dispositif selon la revendication 1, **caractérisé en ce que** l'élément de soutien (8) est en la même matière que le substrat (2).

3. Dispositif selon l'une des revendications précédentes, **caractérisé en ce que** plusieurs substrats (2) repose sur un porte-substrat (1).

4. Dispositif selon l'une des revendications précédentes, **caractérisé en ce que** l'élément de soutien (8) a une forme de disque annulaire et repose sur un gradin du corps de base (6).

5. Dispositif selon l'une des revendications précédentes, **caractérisé en ce que** l'élément de soutien (8) est en saphir (Al₂O₃).

6. Dispositif de revêtement d'un substrat, notamment réacteur CVD comportant une chambre de réaction (3),
destiné à déposer des couches sur au moins un substrat (2) qui est maintenu par un porte-substrat (1) selon l'une des revendications 1 à 5, la chambre de réaction (3) étant portée à une température de réaction au moyen d'un dispositif de chauffage (13),
**caractérisé en ce que** la chambre de réaction (3) et raccordée à une chambre de traitement (12) destinée à effectuer un traitement optique ultérieur sensiblement à la même température de réaction que celle du substrat (2) porté par le porte-substrat (1) ou à une température légèrement inférieure.

7. Dispositif selon la revendication 6, **caractérisé en ce que** le porte-substrat (1) repose dans la chambre de réaction (3) sur un support de porte-substrat (18) qui est chauffé par en-dessous.

8. Dispositif selon la revendication 6, **caractérisé en ce que** le support de porte-substrat (18) est monté de façon à être entraîné en rotation notamment sur un coussin à gaz.

9. Dispositif selon l'une des revendications 6 à 8, **caractérisé en ce que** l'élément de soutien (8) repose sur le support de porte-substrat (18).

10. Dispositif selon l'une des revendications 6 à 9, **caractérisé en ce que** la chambre de traitement (12) comporte un système laser (21) comme source de lumière, ladite source de lumière émettant notamment une lumière à la longueur d'onde de 355 nm.

11. Procédé pour déposer au moins une couche sur au moins un substrat (2), dans lequel le substrat (2), reposant sur un porte-substrat (1) dans une chambre de réaction (3) d'un boîtier de réacteur (15) selon l'une des revendications précédentes, est doté d'un revêtement à une température de réaction et est ensuite soumis à une lumière depuis le bas tout en reposant sur le même porte-substrat (1) sans refroidissement important ou avec un faible refroidissement afin d'influer et, éventuellement, de graver l'interface entre la couche et le substrat (2).

12. Procédé selon la revendication 11, **caractérisé en ce que** la température de réaction est > 900°C, > 1000°C ou > 1100°C.

13. Procédé selon la revendication 11 ou 12, **caractérisé en ce qu'**une couche de nitrite de gallium, d'une épaisseur de plusieurs micromètres et servant notamment de pseudo-substrat, est déposée sur un substrat de saphir.

14. Procédé selon l'une des revendications 11 à 13, **caractérisé en ce que** le dépôt est effectué par le biais de gaz réactifs introduits dans la chambre de réaction (3).

15. Procédé selon la revendication 14, **caractérisé en ce que** les gaz introduits dans la chambre de réaction contiennent des éléments des troisième et cinquième ou des deuxième et sixième groupes principaux et notamment des chlorures et des hydrures, par exemple du chlorure de gallium et du NH₃.
